# EUROPEAN PATENT SPECIFICATION

(11) **EP 2 872 906 B1**
(45) Date of publication and mention of the grant of the patent: **15.02.2017**
(21) Application number: 12762409.6
(22) Date of filing: 11.07.2012
(51) Int. Cl.: G01R 31/319, G01R 1/04, G01R 31/28

(54) **INTERFACE BOARD OF A TESTING HEAD FOR A TEST EQUIPMENT OF ELECTRONIC DEVICES AND CORRESPONDING TESTING HEAD**
SCHNITTSTELLENKARTE EINES PRÜFKOPFES FÜR EINE TESTEINRICHTUNG ELEKTRONISCHER VORRICHTUNGEN UND ENTSPRECHENDER PRÜFKOPF
CARTE D'INTERFACE D'UNE TÊTE DE TEST POUR UN ÉQUIPEMENT DE TEST DE DISPOSITIFS ÉLECTRONIQUES ET TÊTE DE TEST CORRESPONDANTE

(43) Date of publication of application: 20.05.2015
(73) Proprietor: Technoprobe S.p.A, 23870 Cernusco Lombardone (Lecco) (IT)
(72) Inventor: CAMPARDO, Giovanni, I-23870 Cernusco Lombardone (Lecco) (IT); MAGGIONI, Flavio, I-23870 Cernusco Lombardone (Lecco) (IT); LIBERINI, Ricardo, I-23870 Cernusco Lombardone (Lecco) (IT)
(74) Representative: Ferrari, Barbara
(86) International application number: PCT/IT2012/000214
(87) International publication number: WO 2014/009980

(56) References cited:
- EP-A1- 1 724 598
- US-A- 5 477 160
- US-A1- 2004 017 216

## Description

### Field of application

The present invention relates to an interface board of a testing head for a test equipment of electronic devices.

The invention relates particularly, but not exclusively, an interface board of a testing head for a test equipment of wafer-integrated electronic devices and the following description is made with reference to this field of application with the sole purpose of simplifying the explanation thereof.

### Prior art

As it is well known, a testing head is essentially a device suitable to electrically connect a plurality of contact pads of a microstructure, particularly a wafer-integrated electronic device, with corresponding channels of a test equipment performing the functionality check thereof, particularly the electrical one, or generically the test.

For example, the document US 2004/0017216 A1 discloses an interface structure for routing test signals between ball grid array packaged integrated circuits and integrated circuit device testers.

The test performed on integrated devices serves in particular to detect and isolate defective devices, already in the production step. Normally, testing heads are then used for the electrical test of wafer-integrated devices before cutting and mounting them within a chip containment package.

A testing or probe head essentially comprises a plurality of mobile contact elements or contact probes equipped with at least one contact portion or tip for a corresponding plurality of contact pads of a device to be tested. The terms end or tip indicate here and hereafter an end portion, being not necessarily pointed.

It is then known that the efficacy and the reliability of a testing test also depend, among other factors, on the realization of a good electrical connection between the device and the test equipment, then, on an optimum probe/pad electrical contact.

Among the typologies of testing heads used in the technical field being here considered for testing integrated circuits, the so-called testing head with cantilever probes, also called cantilever testing heads are widely used, which just have probes projecting like a fishing rod over a device to be tested.

In particular, a cantilever testing head of the known type normally supports a plurality of probes, which are flexible, generally in the form of a wire, with predetermined electrical and mechanical properties. The probes, cantilevering from the cantilever testing head, have a substantially hooked shape, due to the presence of a substantially elbow-bent end section having a generally obtuse inner angle.

The good connection between the probes of a cantilever testing head and the contact pads of a device to be tested is ensured by pressing the testing head on the device itself, the probes undergoing on this occasion a vertical flexure (with respect to the plane defined by the device to be tested) in an opposite sense to the movement of the device towards the testing head.

The probe hooked shape is such that, during the contact with the contact pads of the device to be tested and the probe travel upwards beyond a predetermined contact point, commonly called "overtravel", the probe contact tips slide on the contact pads for a length commonly called "scrub".

This technique, although advantageous when adopted for the application to integrated circuits of the type conventionally used until not long ago, proves unsuitable for the testing of late-design integrated circuits, having problems linked to an intrinsic limitation in the probe density and in the parallelism thereof.

In order to overcome these drawbacks, it is known to use testing heads called vertical probe head. A vertical probe head essentially comprises a plurality of contact probes held by at least one pair of plates or guides being substantially plate-like and parallel to each other. These guides are equipped with suitable holes and positioned at a certain distance from each other so as to leave a free area or an air gap for the movement and possible deformation of contact probes. The pair of guides comprises in particular an upper guide and a lower guide, both provided with guide holes in which the contact probes axially slide, normally formed by wires of special alloys with good electrical and mechanical properties.

The good connection between the testing probes and the contact pads of the device being tested is, in that case too, ensured by pressing the testing head on the device itself, the contact probes, mobile in the guide holes realized in the upper and lower guides, undergoing, during such a pressing contact, a flexure inside the air gap between the two guides and a sliding inside such guide holes.

Moreover the flexure of contact probes in the air gap can be helped through an appropriate configuration of the probes themselves or of their guides, particularly using pre-deformed contact probes or appropriately shifting the plates comprising them.

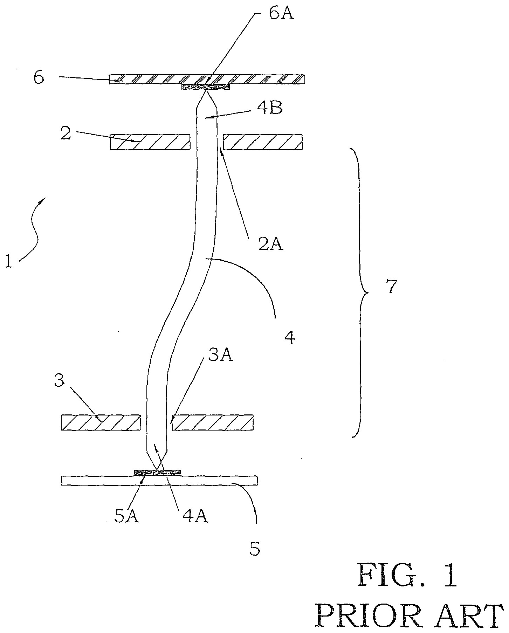

Figure 1 schematically shows a testing head 1 comprising at least one upper plate or guide 2 and one lower plate or guide 3, having respective upper 2A and lower 3A guide holes, in which at least one contact probe 4 slides.

The contact probe 4 has at least one contact end or tip 4A. In particular the contact tip 4A abuts against a contact pad 5A of a device 5 to be tested, making the mechanical and electrical contact between said device and a test equipment (not represented), of which such a testing head forms a terminal element.

In general, testing heads are used, that have probes not being fixedly constrained, but held interfaced with a board, connected in turn to the test equipment: these are testing heads with unlocked probes.

In this case, as shown in figures 1, the contact probe 4 has a further contact tip 4B, usually indicated as contact head, towards a plurality of contact pads 6A of the board 6. The good electrical contact between the probes and the board is ensured similarly to the contact with the device to be tested by pressing the probes on the contact pads of the board.

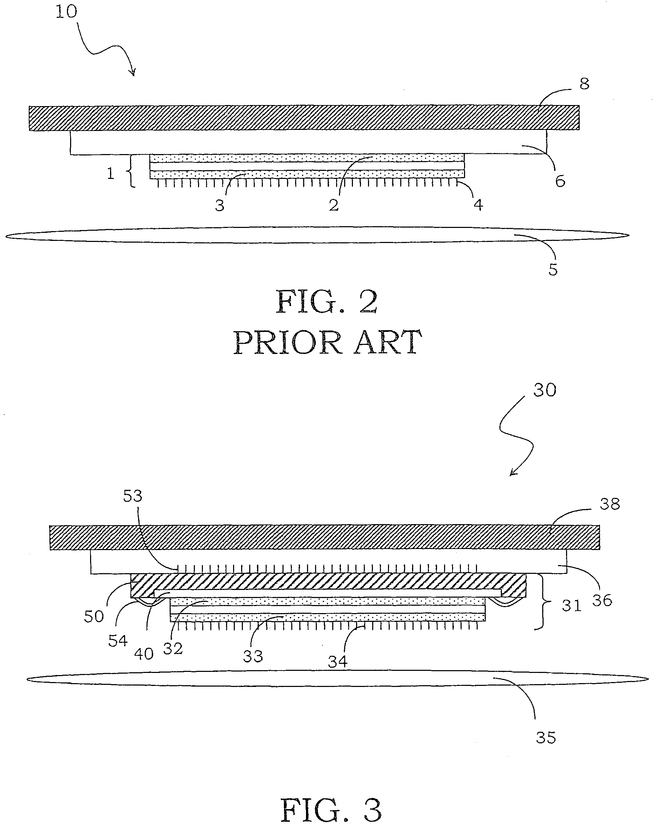

Furthermore, the board 6 is kept in position by means of a stiffener. The combination of the testing head, of the board and of the stiffener forms a terminal portion of the test equipment, globally indicated with 10 in Figure 2.

In the vertical probe technology, it is then important to ensure also the good connection of the contact probes with the test equipment, in particular in correspondence with the contact heads thereof and then with the board.

Another critical parameter in realizing a testing head is the distance (the so-called pitch) between the centres of the contact pads on the device to be tested. The pitch of integrated electronic devices, with the development of the corresponding manufacturing technologies, has become smaller and smaller, forcing to a high packing of contact probes 4 in the testing head 1, with the related positioning problems so as to avoid the reciprocal contact. These distance constraints are instead slightly less binding for the contact pads on the board 6, these pads being allowed to be more spaced and arranged in a more free way, in particular more regularly, if compared to those of the device to be tested.

Several technologies for realizing the board 6 associated to the testing head 1 in the terminal portion 10 of the test equipment are known.

In particular, a first solution uses the printed circuit techniques to realize the board 6, which is also commonly indicated as PCB. This technology allows boards with also-big-sized active areas to be realized, but with great limitations in comparison with a minimum reachable value for the pitch in high density conditions of the contact pads on the device to be tested.

The ceramic-based technology or MLC, acronym of the English "Multilayer Ceramic" is also known. Such a technology allows very low pitches to be obtained and higher densities in comparison with the PCB technology, but it inserts limitations on the highest number of signals which can be used for the testing and on the biggest size of the active area which can be housed on the board.

Finally, it is possible to use a so-called hybrid technology in which the testing head is interfaced with an intermediate board, commonly indicated with interposer, connected in turn to a mechanical support, commonly indicated with plug and connected through welding bridges to the board. This technology offers a great flexibility in terms of surface, pitch and density of signals, but it turns out to be limited in the highest number of processable signals, also having worse electromagnetic performances. A not least disadvantage of the hybrid technology is the difficult automation thereof.

The technical problem of the present invention is to provide a board for a testing head equipped with a plurality of contact probes for the connection with a test equipment of electronic devices, in particular wafer-integrated, having such structural and functional features as to allow the limitations and drawbacks still afflicting the boards realized with known technologies to be overcome, in particular allowing the testing of devices with a high density of contact pads to be handled.

### Summary of the invention

The solution idea underlying the present invention is to associate to the board of a testing head for the connection with the test equipment an interface board which is realized using the photolithographic techniques commonly used to realize the integrated devices to be tested.

Based on this solution idea the technical problem is solved by an interface board of a testing head for a test equipment of electronic devices, such a testing head comprising a plurality of contact probes, each contact probe having at least one contact tip suitable to abut against contact pads of a device to be tested, as well as a contact element for the connection with a board of the test equipment, characterized in that it comprises a substrate and at least one redirecting die housed on a first surface of the substrate and a plurality of contact pins projecting from a second surface of the substrate opposed to the first surface, the redirecting die comprising at least one semiconductor substrate whereon at least a first plurality of contact pads is realized being suitable to contact a contact element of a contact probe of the testing head, the contact pins being suitable to contact the board.

More particularly, the invention comprises the following additional and optional features, taken individually or in case in combination.

According to an aspect of the invention, the contact pads of the first plurality may be distributed in a first central portion of the redirecting die with a spatial distribution substantially corresponding to a spatial distribution of a plurality of contact pads of the device to be tested.

According to another aspect of the invention, the board may further comprise a second plurality of contact pads distributed in a second peripheral portion of the redirecting die and connected to the contact pads of the first plurality by means of a plurality of metallic interconnection tracks realized in the substrate of the redirecting die, the second peripheral portion surrounding the first central portion.

In particular, according to an aspect of the invention, the first central portion may have a substantially rectangular shape and the second peripheral portion may have a substantially rectangular ring-like shape around the first central portion.

According to an aspect of the invention, the board may further comprise a plurality of metallic pads realized on a peripheral portion of the substrate of the interface board left free from the redirecting die and connected to the contact pins.

According to such an aspect of the invention, the board may also comprise a plurality of bonding wires suitable to connect the metallic pads with the contact pads of the second plurality.

According to another aspect of the invention, the redirecting die may comprise a package of the PGA type being free of lid.

Moreover, according to another aspect of the invention, the redirecting die may comprise wire bonding connections of direct connection between the second plurality of contact pads and contact pads arranged in the board of the test equipment.

Furthermore, according to yet another aspect of the invention, the redirecting die may comprise connections of the TSV type between the two surfaces thereof in correspondence with the contact pads of the second plurality.

According to an aspect of the invention, the redirecting die may also comprise additional electrical components realized in the substrate thereof.

Moreover, according to an aspect of the invention, the redirecting die may comprise a logic testing portion regulating the connection between its pads and the contact probes.

According to another aspect of the invention, the redirecting die may have a size being substantially equal to a wafer comprising a plurality of devices to be tested.

Furthermore, according to an aspect of the invention, the interface board may comprise at least one parallel testing module including in turn a plurality of redirecting dice arranged as a matrix and appropriately spaced from each other by means of separation passages.

According to this aspect of the invention, the parallel testing module may also comprise a plurality of slots realized in the separation passages and suitable to cross a substrate of the parallel testing module so as to house bonding wires for the connection with the metallic pads realized on the substrate of the interface board in correspondence with the slots.

The technical problem is also solved by a testing head for a test equipment of electronic devices of the type comprising a plurality of contact probes, each contact probe having at least one contact tip suitable to abut against contact pads of a device to be tested, as well as a contact element for the connection with a board of the test equipment, characterized in that it comprises at least one interface board as above described.

Finally, the technical problem is solved by a method for realizing an interface board of a testing head for a test equipment of electronic devices, the testing head comprising a plurality of contact probes, each contact probe having at least one contact tip suitable to abut against contact pads of a device to be tested, as well as a contact element for the connection with a board of the test equipment, the method comprising the steps of:
- providing a substrate for the interface board realized with the printed circuit techniques;
- integrating a redirecting die on a semiconductor substrate using the integration techniques of the integrated circuits;
- housing the redirecting die on a first surface of the substrate of the interface board; and
- electrically connecting a plurality of contact pads of the redirecting die with a plurality of contact pins projecting from a second surface of the substrate opposed to the first surface whereon the redirecting die is housed,
the contact pins being suitable to contact corresponding contact pads of a board for realizing the desired connection with the test equipment.

According to an aspect of the invention, the step of integrating the redirecting die on the semiconductor substrate may comprise the steps of:
- realizing a first plurality of contact pads distributed in a first central portion of the redirecting die;
- realizing a second plurality of contact pads distributed in a second peripheral portion of the redirecting die, the second peripheral portion having a ring-like shape around the first central portion; and
- realizing a plurality of metallic interconnection tracks, suitable to connect the contact pads of the first central portion with the contact pads of the second peripheral portion of the redirecting die.

According to another aspect of the invention, the step of realizing the first plurality of contact pads distributed in the first central portion of the redirecting die may comprise a step of positioning the contact pads in a spatial way corresponding to a plurality of contact pads realized on a device to be tested.

Moreover, according to another aspect of the invention, the step of integrating the redirecting die on the semiconductor substrate may comprise the steps of back end masking used in the integration techniques of the integrated circuits for realizing the contacts and the connections.

According to an aspect of the invention, the steps of back end masking use the masks of the metallizations, contacts and vias and of the passivation.

According to an aspect of the invention, the method may further comprise the steps of:
- realizing a plurality of metallic pads on the substrate of the interface board, into electrical connection with the contact pins; and
- connecting the metallic pads to the contact pads of the second peripheral portion of the redirecting die by means of bonding wires.

According to another aspect of the invention, the method may further comprise a step of connecting the contact pads of the second peripheral portion of the redirecting die to the contact pads of the board of the test equipment.

According to an aspect of the invention, the method may further comprise a step of positioning the redirecting die in a centred way in comparison with the substrate of the interface board before performing the step of housing the redirecting die on a first surface of the substrate.

According to another aspect of the invention, the step of housing the redirecting die on a first surface of the substrate of the interface board may comprise a step among the following:
- gluing the redirecting die on the first surface of the substrate; and
- welding the redirecting die on the first surface of the substrate.

Moreover, according to an aspect of the invention, the step of housing the redirecting die on a first surface of the substrate may preventively comprise a step of associating the redirecting die to an intermediate base.

According to another aspect of the invention, the method may comprise a step of realizing connections of the TSV type in the redirecting die so as to contact the two surfaces thereof, these connections of the TSV type being realized in correspondence with the contact pads of the second peripheral portion of the redirecting die.

According to yet another aspect of the invention, the step of integrating the redirecting die on the semiconductor substrate may comprise a step of encapsulating the redirecting die in a package of the PGA type, being appropriately free of lid.

Finally, according to an aspect of the invention, the method may further comprise a step of integrating additional electrical components and/or a portion of a testing logic in the semiconductor substrate of the redirecting die.

The features and advantages of the interface board, of the testing head and of the method according to the invention will be apparent from the following description of an embodiment thereof given by way of not limiting example with reference to the attached drawings.

### Brief description of the drawings

In these drawings:
- Figure 1 schematically shows a contact probe for a vertical probe head realized according to the prior art;
- Figure 2 schematically shows a terminal portion of a test equipment comprising a vertical probe head realized according to the prior art;
- Figure 3 schematically shows a terminal portion of a test equipment comprising an interface board according to an embodiment of the invention;
- Figure 4 schematically shows a redirecting die of an interface board according to an embodiment of the invention;
- Figure 5 schematically shows an interface board according to an embodiment of the invention;
- Figure 6 schematically shows a parallel testing module of an interface board according to a further embodiment of the invention;
- Figure 7 schematically shows an interface board according to a further embodiment of the invention; and
- Figure 8 schematically shows a semiconductor wafer comprising at least one parallel testing module of Figure 6.

### Detailed description

With reference to these figures, and in particular to Figure 3, a terminal portion of a test equipment comprising a testing head equipped with a plurality of contact probes for the testing of electronic devices, in particular wafer-integrated devices, is globally indicated with 30. Hereafter, for simplicity this terminal portion of the test equipment (not represented) will be indicated as test block 30.

It should be noted that the figures are schematic views of the system according to the invention and they are not drawn in scale, but they are instead drawn so as to emphasize the important features of the invention.

Moreover, the different aspects of the invention represented by way of example in the figures can be obviously combined with each other and interchanged from an embodiment to another.

The test block 30 essentially comprises a testing head 31 in which a plurality of contact probes 34 are housed, as well as a board 36, associated to a stiffener 38 and suitable to connect with a test equipment (not shown). In particular, the testing head 31 comprises at least one upper plate or guide 32 and one lower plate or guide 33, having respective holes in which the contact probes 34 slide.

As already explained with reference to the prior art, each contact probe 34 has at least one contact end or tip suitable to abut against contact pads of a device 35 to be tested, as well as a further contact end or head for the connection with the test equipment (not represented) by means of the board 36, as it will be explained hereafter.

In alternative, the contact probes 34 can be removably associated to a support, for example a ceramic one, equipped with corresponding contact elements with the board 36, for example bumps projecting from the support. In particular, the contact probes 34 can be welded to the support, thus realizing a constrained-probe testing head 31.

However, also in that case, we will talk about a contact element of the corresponding contact probe 34 for the connection with the board 36.

According to an aspect of the invention, the testing head 31 further comprises an interface board 50 interposed between the upper guide 32 and the board 36. More particularly, the interface board 50 comprises a redirecting die 40 whereon the contact elements of the contact probes 34 of the testing head 31 abut and equipped with a plurality of contact pins 53 for the board 36.

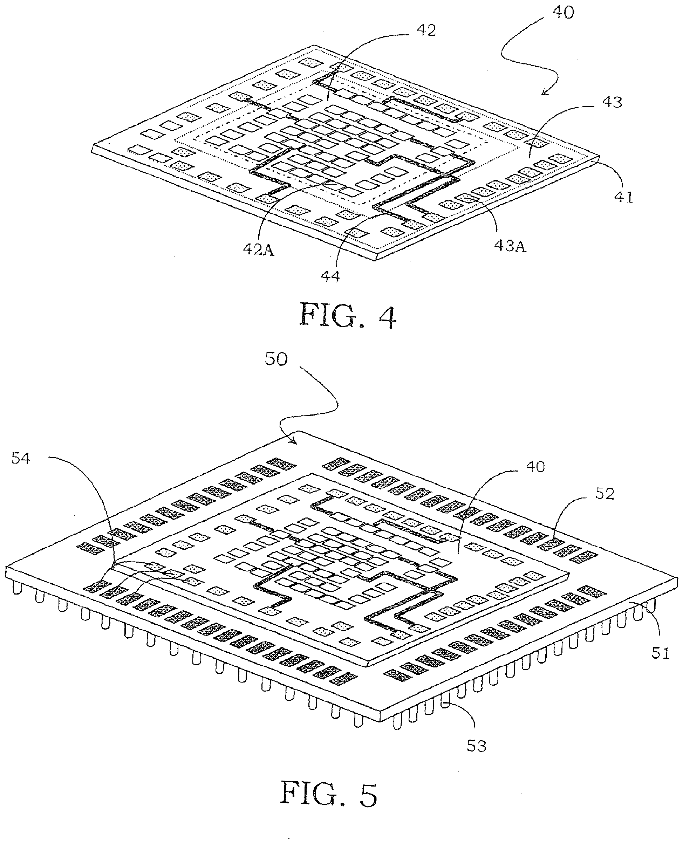

The redirecting die 40 is shown in greater detail in Figure 4. It comprises a substrate 41 of substantially rectangular shape and a plurality of contact pads distributed on the substrate 41.

More particularly, the contact pads of the redirecting die 40 comprise a first plurality of contact pads 42A distributed in a first central portion 42 of substantially rectangular shape of the redirecting die 40 and a second plurality of contact pads 43A distributed in a second peripheral portion 43 of the redirecting die 40, the second peripheral portion 43 having a rectangular ring-like shape around the first central portion 42. Obviously, different distributions of the second plurality of contact pads 43A are possible in comparison with what illustrated in Figure 4 by simple way of example. It is possible for example to distribute that second plurality of contact pads 43A in a generally "staggered" way.

According to an aspect of the invention, the substrate 41 is a semiconductor substrate and the contact pads of the first plurality and of the second plurality, 42A and 43A, are realized therein using the lithographic technology of semiconductor integrated circuits.

In fact, the present invention arises from the consideration that the fundamental problem connected to realizing a testing block 30 comprising a board, be it in the PCB technology or in ceramic, is linked to the dimensional constraints of the device to be tested, which is realized with technologies of the photolithographic type, compared with those of the technologies used for realizing the board for the test equipment. In particular, the greatest difficulties are linked to passing from connections having contact pads with a certain pitch, being the distance between the centres of the pads themselves, to connections with pads which are realized in another technology and should have an acceptable pitch so as to avoid the contact problems between probes and ensure the correct contact between the device to be tested and the test equipment.

It is also known that the progress in the lithographic technologies allowing the integrated circuits to be realized makes the spatial transformation from the distances between the contact pads of the devices to be tested toward those between the contact pads of the board of the test equipment more and more difficult. In known solutions, this transformation is obtained at the cost of the insertion of different elements, with different features constituting a spatial 'decoding' able to put the connections of the device to be tested, in particular the contact pads thereof, in communication with the connectors reaching the test equipment, in particular the contact probes.

The present invention arises then from the acknowledgement of the fact that the most critical point, in this spatial decoding chain, is the portion receiving the contact of the contact elements of the probes included in the testing head and contacting on the side of their tips the contact pads of the device to be tested, while with their contact elements they contact the board towards the side of the test equipment.

According to an aspect of the invention, the contact pads 42A of the first central portion 42 are distributed in a way corresponding to the contact pads of the device 35 to be tested, while the contact pads 43A of the second peripheral portion 43 are distributed along the edges of the redirecting die 40. Appropriately, the contact pads 43A of the second peripheral portion 43 can be realized with a suitable pitch and size to easily couple with the board 36, not being, as it will be apparent from the rest of the description, constrained from the distribution of the contact pads of the device to be tested.

Moreover, the redirecting die 40 comprises a plurality of metallic interconnection tracks 44, suitable to connect the contact pads 42A of the first central portion 42 with the contact pads 43A of the second peripheral portion 43.

In particular, the contact pads 42A of the first central portion 42 are contacted by the contact elements of the contact probes 34 while the contact pads 43A of the second peripheral portion 43 are suitable to connect with the board 36 and then with the test equipment.

In greater detail, as shown in Figure 5, the redirecting die 40 is included in an interface board 50, in turn in contact with the board 36. The interface board 50 comprises a substrate 51, realized in particular with the PCB technology and comprising a plurality of metallic pads 52 connected by means of bonding wires 54 to the contact pads 43A of the second peripheral portion 43 of the redirecting die 40. The plurality of metallic pads 52 of the interface board 50 is then connected to a plurality of contact pins 53, projecting from a surface of the substrate 51 opposed a that whereon the redirecting die 40 is housed and suitable to contact corresponding contact pads of the board 36 for realizing the desired connection with the test equipment.

In particular, the interface board 50 is realized removably associating the redirecting die 40 on a surface of the substrate 51, appropriately in a central position, the substrate 51 having a larger size than the redirecting die 40 so that the redirecting die 40, once positioned, leaves a peripheral crown of the substrate 51 free whereon it is possible to realize the pads 52 and to perform the bonding with the contact pads 43A of the second peripheral portion 43 of the redirecting die 40.

In a first embodiment of the invention, the redirecting die 40 is realized in the form of a package of the PGA (Pin Grid Array) type and is associated to the substrate 51 of the interface board 50, for example by gluing or welding, using in case an intermediate base (not shown) between the redirecting die 40 and the substrate 51.

In that case, differently from the known packages of the PGA type, the containment package of the redirecting die 40 is not sealed with a lid so as to allow the contact elements of the contact probes 34 of the testing head 31 to contact the contact pads 42A of the first central portion 42 of the redirecting die 40.

It is suitable to note that for realizing the redirecting die 40 it is not necessary to use a complete flow of an integration process of a semiconductor device. In fact it is enough to provide the substrate 41 and use the final masks, the so-called back end masks, which, in the semiconductor device integration processes, are used to realize the contacts and the connections. It is then possible to realize the redirecting die 40 without implementing the most recent integration technologies, reducing the realization costs of that redirecting die 40. More particularly, for realizing the redirecting die 40, only the back end masks are used, i.e. the masks of the metallizations, contacts and vias and finally of the passivation so as to open the areas in which the contact probes 34 will abut.

In a second embodiment, the redirecting die 40 is fastened directly to the interface board 50, realizing the connections of wire bonding directly between the second plurality of contact pads 43A of the redirecting die 40 and the contact pads arranged in the board 36 and saving any intermediate connection, in particular bonding wires.

In a third embodiment, connections of the TSV (Through Silicon Vias) type are realized on the redirecting die 40, so as to put into contact the two surfaces of the redirecting die 40 itself. In particular, it is possible to realize these TSV connections by means of through holes, appropriately metalized and positioned accordingly. It is thus possible to eliminate bonding wires and directly connect, for example through a bumping process, the contact pads 43A of the second peripheral portion 43 of the redirecting die 40, connected by means of the metallic interconnection tracks 44 to the contact pads 42A of the first central portion 42 whereon the contact elements of the contact probes 34 of the testing head 31 abut, with the back side of the redirecting die 40 and directly with the board 36.

It should be noted that, according to this embodiment, it is possible to obtain a better connection from the electrical point of view since the paths of the metallic interconnection tracks 44 are reduced and the bonding wires 54 are eliminated, with a simplification of the whole testing block 30. In this case, the redirecting die 40 is mounted directly on the board 36.

According to an alternative embodiment, additional electrical components are realized on the redirecting die 40, comprising active or passive components, in particular inductors, capacitors and resistors, obtained by using the conventional layers provided by the lithographic technique through which the redirecting die 40 is realized.

According to a further alternative embodiment, also a testing logic portion is integrated on the redirecting die 40, allowing the contact probes 34 to be connected in a simpler way to the device 35 to be tested with the test equipment.

Still according to another alternative embodiment, the redirecting die 40 is realized with a size similar to a silicon wafer which comprises a plurality of devices to be tested. It is thus possible to perform the parallel testing of all the devices integrated on an entire wafer with a single test touch down of the testing block 30 comprising such a redirecting die 40, which reproduces the "image" of all the devices integrated on the wafer.

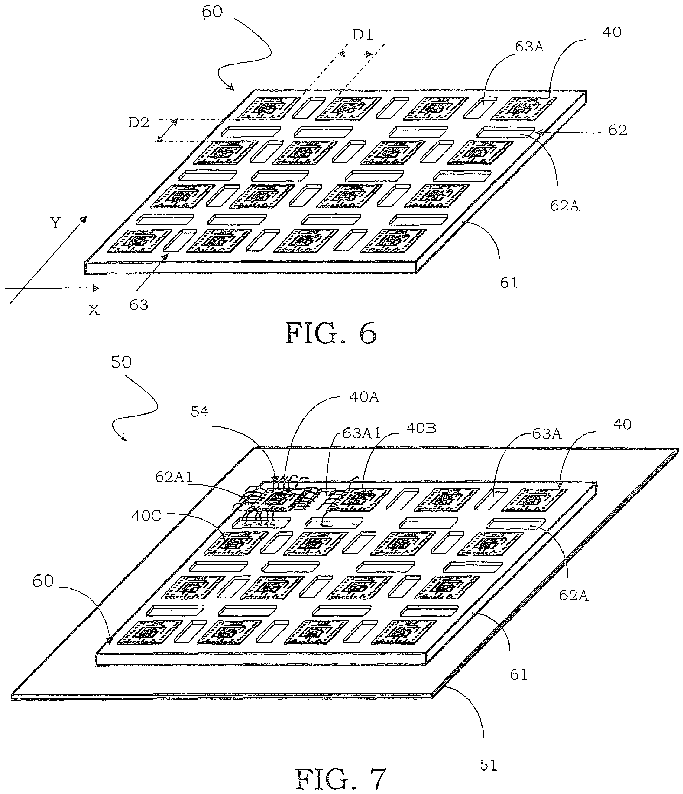

It is also possible to perform the parallel testing of a plurality of devices realizing a parallel testing module 60 comprising a plurality of redirecting dice 40, as schematically illustrated in Figure 6.

The parallel testing module 60 comprises a substrate 61 whereon a plurality of redirecting dice 40 is realized, as above described. In particular, each redirecting die 40 comprises a first plurality of contact pads distributed in a central portion thereof and a second plurality of contact pads distributed in a peripheral portion thereof, the single redirecting die 40, and in particular the central portion thereof having pads arranged in a way corresponding to the contact pads of the device to be tested, in a substantially "mirrored" manner.

According to an aspect of the invention, the redirecting dice 40 are arranged on the substrate 61 so as to be appropriately spaced according to the development directions of that substrate 61, in particular a transverse development direction and a longitudinal development direction, indicated as X and Y in Figure 6.

As shown in that figure, two adjacent redirecting dice 40 according to the transverse development direction X are spaced by a first distance D1 and two adjacent redirecting dice 40 according to the longitudinal development direction Y are spaced by a second distance D2. In other words, the redirecting dice 40 are arranged substantially as a matrix, a plurality of first separation passages 62 being defined according to the transverse development direction X and a plurality of second separation passages 63 being defined according to the longitudinal development direction Y.

According to an aspect of the invention, respective first slots 62A are realized in the first separation passages 62 in correspondence with the redirecting dice 40 and having at least one dimension, in particular a length, substantially equal to that of the redirecting dice 40 which are adjacent thereto. In that way, pairs of side-by-side redirecting dice 40 along the transverse development direction X are spaced from a first slot 62A having a length substantially equal to the dimension of the redirecting dice 40 along the transverse development direction X.

Similarly, respective second slots 63A are realized in the first separation passages 62 in correspondence with the redirecting dice 40 and having at least one dimension, in particular a length, substantially equal to that of the redirecting dice 40 which are adjacent thereto. In that way, pairs of side-by-side redirecting dice 40 along the longitudinal development direction Y are separate from a second slot 63A having a length substantially equal to the dimension of the redirecting dice 40 along the longitudinal development direction Y.

In substance, the parallel testing module 60 includes a plurality of redirecting dice 40 arranged as a matrix and appropriately spaced from each other by means of separation passages 62 and 63.

The parallel testing module 60 is removably associated with the substrate 51 of the interface board 50, which is thus suitable for performing the parallel testing of a plurality of devices.

As above described, on the substrate 51 of the interface board 50 a plurality of metallic pads connected by means of bonding wires 54 with the contact pads of the peripheral portion of the redirecting dice 40 is realized. According to an aspect of the invention, metallic pads are also realized in correspondence with the first and second slots 62A and 63A.

It is thus possible to connect all the contact pads of the peripheral portions of all the redirecting dice 40 included in the parallel testing module 60 to corresponding metallic pads of the interface board 50 without using bonding wires which are particularly long or which should be let pass over the other bonding wires. On the contrary, thanks to the presence of the first slot 62A and of the second slot 63A in the parallel testing module 60, it is possible to use, for the connection of the redirecting dice 40 which are present therein, the bonding wires 54 of a same length, in particular for all the connections between the contact pads of the peripheral portion of each redirecting die 40 and the metallic pads realized on the substrate 51 of the interface board 50.

The plurality of metallic pads of the interface board 50 can be then connected to a plurality of contact pins, projecting from a surface of the substrate 51 opposed to that whereon the redirecting die 40 is housed and suitable to contact corresponding contact pads of the board 36 for realizing the desired connection with the test equipment, as above described.

In greater detail, in Figure 7, it is underlined how a redirecting die, for example the first die 40A, of the parallel testing module 60 is flanked, along the transverse development direction X, by a first slot 62A1 which spaces it from a second die 40B which is adjacent thereto along that transverse development direction X and is flanked, along the longitudinal development direction Y, by a second slot 63A2 which spaces it from a third die 40C which is adjacent thereto along that longitudinal development direction Y.

Furthermore, the first die 40A comprises a plurality of bonding wires 54 connected to the contact pads of the peripheral portion thereof, in correspondence with the four sides thereof. According to an aspect of the invention, at least a first plurality of bonding wires 54 is realized so as to slip into the first slot 62A1 and at least a second plurality of bonding wires 54 is realized so as to slip into the second slot 63A 1. Suitably, metallic pads of the interface board 50 are realized on its substrate 51 in correspondence with that first slot 62A1 and second slot 63A1 and suitably connected, by means of the bonding wires 54, to the contact pads of the peripheral portion of the first die 40A.

In substance, the parallel testing module 60 comprises a plurality of slots, the first slots 62A and the second slots 63A, realized in the separation passages 62 and 63 of the redirecting dice 40, these slots being realized so as to cross a substrate 61 in order to be able to house the bonding wires 54 for the connection with metallic pads realized on the substrate 51 of the interface board 50 just in correspondence with the slots.

It is then evident that the configuration of the parallel testing module 60, thanks to the presence of the first slots 62A and of the second slots 63A, can be realized with a wire bonding process similar to the one used for a single redirecting die 40 of the type shown in figures 4 and 5. Moreover, in such a wire bonding process, bonding wires 54 of a same length are used for the connections on all the four sides of each redirecting die 40.

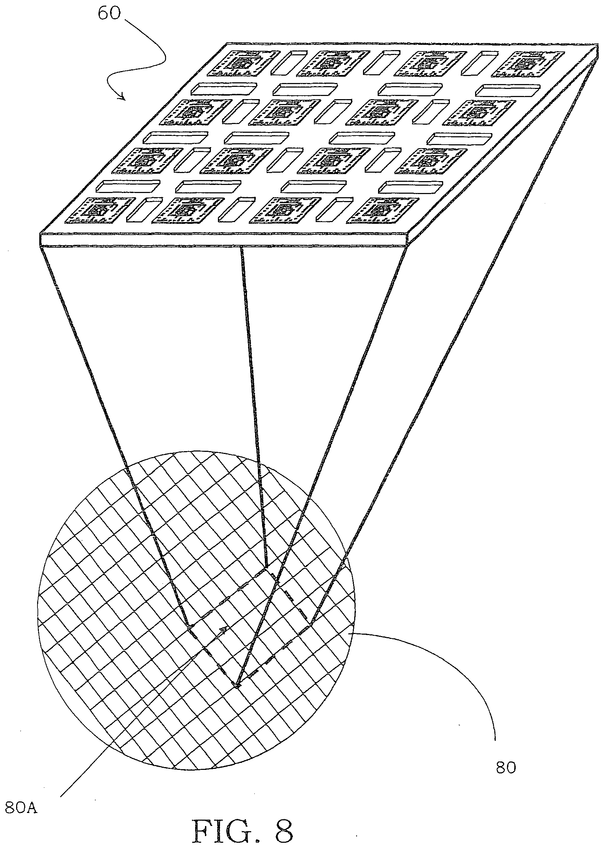

It should be underlined that a parallel testing module 60 can be drawn by means of an appropriate partition of a silicon wafer in which a plurality of redirecting dice 40 has been distributed. In particular, as schematically illustrated in Figure 8, the parallel testing module 60 is realized from an appropriate portion 80A of a wafer 80 whereon the redirecting dice 40 are realized.

Obviously, the distribution process of the redirecting dice 40 should be realized so as to leave the distances D1 and D2 between adjacent dice according to the transverse and longitudinal development directions, i.e. to set first passages 62 and second passages 63 between the redirecting dice 40 which are substantially arranged as a matrix on the substrate 61, as explained with reference to Figure 6, that substrate 61 corresponding to the substrate of the wafer 80.

Furthermore, it is underlined that the first slots 62A and the second slots 63A can be realized in the passages 62, 63 through a laser process performed on that substrate 61.

The invention also relates to a testing head 31 of the type comprising a plurality of contact probes 34, as well as an interface board 50 interposed between the upper guide 32 and a board 36 of a test equipment.

In particular, each contact probe 34 is equipped with a contact tip suitable to abut against contact pads of a device 35 to be tested and with a contact head suitable to perform the connection with a board 36 of the test equipment. In that case, the testing head 31 comprises at least one upper plate or guide 32 and one lower plate or guide 33, having respective holes in which the contact probes 34 slide.

In alternative, each contact probe 34 is removably constrained to a support, for example a ceramic one, and comprises a contact tip suitable to abut against contact pads of a device 35 to be tested and a contact element realized on such a ceramic support suitable to perform the connection with a board 36 of the test equipment. In particular, the contact probes 34 can be welded to the ceramic support, equipped in turn with contact bumps for the board 36.

According to an aspect of the invention, the interface board 50 comprises a redirecting die 40 whereon the contact elements of the contact probes 34 abut and equipped with a plurality of contact pins 53 for the board 36, as above described.

In the case in which the interface board 50 comprises a parallel testing module 60, including in turn a plurality of redirecting dice 40 as illustrated in Figures 6 and 7, the so-obtained testing head is able to test in parallel a plurality of devices, in particular in the same number as the number of redirecting dice 40 included in the parallel testing module 60, such a high testing parallelism not involving any complication for the wire bonding process to be used to finalize the interface board 50.

The present invention also relates to a method for realizing the interface board 50 of the testing head 31 comprising the redirecting die 40.

The method essentially comprises the steps of:
- providing a substrate 51 for the interface board 50 realized with the printed circuit techniques;
- integrating a redirecting die 40 on a semiconductor substrate 41 using the integration techniques of the integrated circuits;
- housing the redirecting die 40 on a first surface of the substrate 51; and
- electrically connecting a plurality of contact pads of the redirecting die 40 with a plurality of contact pins 53 projecting from a second surface of the substrate 51 opposed to the first surface whereon the redirecting die 40 is housed.

As already explained, the contact pins 53 are suitable to contact corresponding contact pads of a board 36 for realizing the desired connection with the test equipment.

More particularly, the step of integrating the redirecting die 40 on the semiconductor substrate 41 comprises the steps of:
- realizing a first plurality of contact pads 42A distributed in a first central portion 42 of the redirecting die 40;
- realizing a second plurality of contact pads 43A distributed in a second peripheral portion 43 of the redirecting die 40, the second peripheral portion 43 having a ring-like shape around the first central portion 42; and
- realizing a plurality of metallic interconnection tracks 44, suitable to connect the contact pads 42A of the first central portion 42 with the contact pads 43A of the second peripheral portion 43 of the redirecting die 40.

In particular, the step of realizing the first plurality of contact pads 42A distributed in the first central portion 42 of the redirecting die 40 comprises a step of positioning these contact pads 42A in a spatial way corresponding to a plurality of contact pads realized on the device 35 to be tested.

According to an aspect of the invention, the step of integrating the redirecting die 40 on the semiconductor substrate 41 comprises the steps of back end masking used in the integration techniques of the integrated circuits for realizing the contacts.

More particularly, the steps of back end masking use the masks of the metallizations, contacts and vias and of the passivation.

Furthermore, the method comprises the steps of:
- realizing a plurality of metallic pads 52 on the substrate 51 of the interface board 50, in electrical connection with the contact pins 53; and
- connecting the metallic pads 52 to the contact pads 43A of the second peripheral portion 43 of the redirecting die 40 by means of bonding wires 54.

In alternative, the method comprises a step of connecting the contact pads 43A of the second peripheral portion 43 of the redirecting die 40 to the contact pads of the board 36 of the test equipment, in particular by means of bonding wires.

The method also comprises a step of positioning the redirecting die 40 in a centred way.in comparison with the substrate 51 of the interface board 50 before performing the housing of the same on the first surface of the substrate 51 itself.

Moreover, the step of housing the redirecting die 40 on the first surface of the substrate 51 of the interface board 50 comprises a step between the following:
- gluing the redirecting die 40 on the first surface of the substrate 51; and
- welding the redirecting die 40 on the first surface of the substrate 51.

Moreover, this step of housing the redirecting die 40 on the first surface of the substrate 51 can preventively comprise a step of associating the redirecting die 40 to an intermediate base.

In alternative, the method comprises a step of realizing connections of the TSV type in the redirecting die 40 so as to contact the two surfaces thereof, these connections of the TSV type being realized in correspondence with the contact pads 43A of the second peripheral portion 43 of the redirecting die 40.

Furthermore, the step of integrating the redirecting die 40 on the semiconductor substrate 41 may comprise a step of encapsulating the redirecting die 40 itself in a package of the PGA type, being appropriately free of lid.

Finally, the method may also comprise a step of integrating additional electrical components and/or a testing logic portion in the semiconductor substrate 41 of the redirecting die 40.

It is immediate to verify as the proposed solution allows to overcome the limits still affecting the known technologies.

In particular, by realizing the redirecting die 40 with the technology of the integrated circuits, it is possible to realize the first plurality of contact pads 42A of the first central portion 42 with a pitch being similar to that of the pads of the device 35 to be tested. Moreover, it is possible to "loosen" the distance constraints between the pads of the second plurality of contact pads 43A distributed in the second peripheral portion 43 along the edges of the redirecting die 40, solving the problems tied to the packing of the probes and realizing the desired connection with the board 36 thanks to the contact pins 53, whose spatial distribution is independent from the spatial distribution of the pads of the device 35 to be tested.

Finally, by using a parallel testing module 60 comprising a plurality of redirecting dice 40, it is possible to realize interface boards and then testing heads with a high testing parallelism, without the complications of the process used to realize them.

Obviously, in order to meet contingent and specific requirements, a skilled person in the art could bring several changes and variations to the above described interface board and to the testing head, all included within the scope of protection of the invention as defined by the following claims.

## Claims

1. An interface board (50) of a testing head (31) for a test equipment of wafer-integrated electronic devices, said testing head (31) comprising a plurality of contact probes (34), each contact probe (34) having at least one contact tip suitable to abut against contact pads of a device to be tested (35) integrated on and comprised in a wafer, as well as a contact element for the connection with a board (36) of said test equipment, **characterized in that** it comprises a substrate (51) and at least one redirecting die (40) housed on a first surface of said substrate (51) and a plurality of contact pins (53) projecting from a second surface of said substrate (51) opposed to said first surface, said redirecting die (40) comprising at least one semiconductor substrate (41) whereon at least a first plurality of contact pads (42A) is realized, which is suitable to contact a contact element of a contact probe (34) of said testing head (31), said contact pins (53) being suitable to contact said board (36).

2. An interface board (50) according to claim 1, **characterized in that** said contact pads (42A) of said first plurality are distributed in a first central portion (42) of said redirecting die (40) with a spatial distribution substantially corresponding to a spatial distribution of a plurality of contact pads of said device to be tested (35).

3. An interface board (50) according to claim 2, **characterized in that** it further comprises a second plurality of contact pads (43A) distributed in a second peripheral portion (43) of said redirecting die (40) and connected to said contact pads (42A) of said first plurality by means of a plurality of metallic interconnection tracks (44) realized in said substrate (41) of said redirecting die (40), said second peripheral portion (43) surrounding said first central portion (42).

4. An interface board (50) according to claim 1, **characterized in that** it further comprises a plurality of metallic pads (52) realized on a peripheral portion of said substrate (51) of said interface board (50) left free from said redirecting die (40) and connected to said contact pins (53).

5. An interface board (50) according to claim 4, **characterized in that** it comprises a plurality of bonding wires (54) suitable to connect said metallic pads (52) with said contact pads (43A) of said second plurality.

6. An interface board (50) according to claim 1, **characterized in that** said redirecting die (40) comprises a package of the PGA type being free of lid.

7. An interface board (50) according to claim 3, **characterized in that** said redirecting die (40) comprises wire bonding connections of direct connection between said second plurality of contact pads (43A) and contact pads arranged in said board (36) of said test equipment.

8. An interface board (50) according to claim 3, **characterized in that** said redirecting die (40) comprises connections of the TSV type between the two surfaces thereof in correspondence with said contact pads (43A) of said second plurality.

9. An interface board (50) according to any of the previous claims, **characterized in that** it comprises at least one parallel testing module (60) including in turn a plurality of redirecting dice (40) arranged as a matrix and appropriately spaced from each other from separation passages (62, 63).

10. An interface board (50) according to claim 9, **characterized in that** said parallel testing module (60) comprises a plurality of slots (62A, 63A) realized in said separation passages (62, 63) and suitable to cross a substrate (61) of said parallel testing module (60) so as to house bonding wires (54) for the connection with metallic pads realized on said substrate (51) of said interface board (50) in correspondence with said slots (62A, 63A).

11. A testing head for a test equipment of wafer-integrated electronic devices of the type comprising a plurality of contact probes (34), each contact probe (34) having at least one contact tip suitable to abut against contact pads of a wafer-integrated device to be tested (35), as well as a contact element for the connection with a board (36) of said test equipment, **characterized in that** it comprises at least one interface board (50) according to any of the previous claims.

12. A method for realizing an interface board (50) of a testing head (31) for a test equipment of wafer-integrated electronic devices, said testing head (31) comprising a plurality of contact probes (34), each contact probe (34) having at least one contact tip suitable to abut against contact pads of a device to be tested (35) integrated on and comprised in a wafer, as well as a contact element for the connection with a board (36) of said test equipment, the method comprising the steps of:
- providing a substrate (51) for said interface board (50) realized with the printed circuit techniques;
- integrating a redirecting die (40) on a semiconductor substrate (41) using the integration techniques of the integrated circuits;
- housing said redirecting die (40) on a first surface of said substrate (51) of said interface board (50); and
- electrically connecting a plurality of contact pads of said redirecting die (40) with a plurality of contact pins (53) projecting from a second surface of said substrate (51) opposed to said first surface whereon said redirecting die (40) is housed,
said contact pins (53) being suitable to contact corresponding contact pads of a board (36) for realizing the desired connection with said test equipment.

13. A method according to claim 12, **characterized in that** said step of integrating said redirecting die (40) on said semiconductor substrate (41) comprises the steps of:
- realizing a first plurality of contact pads (42) distributed in a first central portion (42) of said redirecting die (40);
- realizing a second plurality of contact pads (43A) distributed in a second peripheral portion (43) of said redirecting die (40), said second peripheral portion (43) having a ring-like shape around said first central portion (42); and
- realizing a plurality of metallic interconnection tracks (44), suitable to connect said contact pads (42A) of said first central portion (42) with said contact pads (43A) of said second peripheral portion (43) of said redirecting die (40).

14. A method according to claim 12, **characterized in that** said step of integrating said redirecting die (40) on said semiconductor substrate (41) comprises the steps of back end masking used in the integration techniques of the integrated circuits for realizing the contacts and the connections.

15. A method according to claim 13, **characterized in that** it further comprises the steps of:
- realizing a plurality of metallic pads (52) on said substrate (51) of said interface board (50), in electrical connection with said contact pins (53); and
- connecting said metallic pads (52) to said contact pads (43A) of said second peripheral portion (43) of said redirecting die (40) by means of bonding wires (54).

## Patentansprüche

1. Schnittstellenkarte (50) eines Prüfkopfes (31) für eine Testeinrichtung von waferintegrierten elektronischen Vorrichtungen, wobei der Prüfkopf (31) eine Vielzahl an Kontaktsonden (34) umfasst, wobei jede Kontaktsonde (34) zumindest eine Kontaktspitze aufweist, welche geeignet ist gegen Kontaktpads einer zu testenden Vorrichtung (35) aufzuliegen, welche auf einem Wafer integriert und in einem Wafer umfasst sind, sowie ein Kontaktelement für die Verbindung mit einer Karte (36) der Testeeinrichtung, **dadurch gekennzeichnet, dass** sie ein Substrat (51) und zumindest ein Umleitungs-Die (40), welcher auf einer ersten Oberfläche des Substrats (51) untergebracht ist, und eine Vielzahl an Kontaktstiften (53) umfasst, welche aus einer zweiten Oberfläche des Substrats (51) hervorstehen, welche entgegengesetzt zu der ersten Oberfläche ist, wobei der Umleitungs-Die (40) zumindest ein Halbleitersubstrat (41) umfasst, worauf zumindest eine erste Vielzahl von Kontaktpads (42A) realisiert ist, welche geeignet ist, ein Kontaktelement einer Kontaktsonde (34) des Prüfkopfes (31) zu kontaktieren, wobei die Kontaktstifte (53) geeignet sind, die Karte (36) zu kontaktieren.

2. Schnittstellenkarte (50) gemäß Anspruch 1, **dadurch gekennzeichnet, dass** die Kontaktpads (42A) der ersten Vielzahl in einem ersten zentralen Anteil (42) des Umleitungs-Die (40) mit einer räumlichen Verteilung, welche im Wesentlichen einer räumlichen Verteilung einer Vielzahl an Kontaktpads der zu testenden Vorrichtung (35) zugehörig ist.

3. Schnittstellenkarte (50) gemäß Anspruch 2, **dadurch gekennzeichnet, dass** sie weiter eine zweite Vielzahl an Kontaktpads (43A) umfasst, welche in einem zweiten Randanteil (43) der Umleitungsmatrize (40) verteilt und zu den Kontaktpads (42A) der ersten Vielzahl mittels einer Vielzahl von metallischen Verbindungsbahnen (44) verbunden sind, welche in dem Substrat (41) der Umleitungsmatrize (40) realisiert sind, wobei der zweite Randanteil (43) den ersten zentralen Anteil (42) umgibt.

4. Schnittstellenkarte (50) gemäß Anspruch 1, **dadurch gekennzeichnet, dass** sie weiter eine Vielzahl an metallischen Pads (52) umfasst, welche an einem Randanteil des Substrats (51) der Schnittstellenkarte (50) realisiert sind, welche von der Umleitungs-Die (40) freigelassen und mit den Kontaktstiften (53) verbunden ist.

5. Schnittstellenkarte (50) gemäß Anspruch 4, **dadurch gekennzeichnet, dass** sie eine Vielzahl von Bonddrähten (54) umfasst, welche geeignet sind, die metallischen Pads (52) mit den Kontaktpads (43A) der zweiten Vielzahl zu verbinden.

6. Schnittstellenkarte (50) gemäß Anspruch 1, **dadurch gekennzeichnet, dass** die Umleitungsmatrize (40) ein Gehäuse des PGA-Typs umfasst, welches frei von Deckeln ist.

7. Schnittstellenkarte (50) gemäß Anspruch 3, **dadurch gekennzeichnet, dass** der Umleitungs-Die (40) Drahtbondverbindungen einer direkten Verbindung zwischen der zweiten Vielzahl an Kontaktpads (43A) und den Kontaktpads umfasst, welche in der Karte (36) der Testeinrichtung angeordnet sind.

8. Schnittstellenkarte (50) gemäß Anspruch 3, **dadurch gekennzeichnet, dass** die Umleitungs-Die (40) Verbindungen des TSV-Typs zwischen den zwei Oberflächen davon in Übereinstimmung mit den Kontaktpads (43A) der zweiten Vielzahl umfasst.

9. Schnittstellenkarte (50) gemäß einem der vorhergehenden Ansprüche, **dadurch gekennzeichnet, dass** sie zumindest ein paralleles Testmodul (60) umfasst, welche wiederum eine Vielzahl von Umleitungs-Dies (40) beinhaltet, welche als Matrix angeordnet sind und entsprechend voneinander von Trennabschnitten (62, 63) beabstandet sind.

10. Schnittstellenkarte (50) gemäß Anspruch 9, **dadurch gekennzeichnet, dass** das parallele Testmodul (60) eine Vielzahl an Schlitzen (62A, 63A) umfasst, welche in den Trennabschnitten (62, 63) realisiert sind und geeignet sind, ein Substrat (61) des parallelen Testmoduls (60) zu kreuzen, um Bonddrähte (54) für die Verbindung mit metallischen Pads unterzubringen, welche an dem Substrat (51) der Schnittstellenkarte (50) in Übereinstimmung mit den Schlitzen (62A, 63A) realisiert sind.

11. Prüfkopf für eine Testeinrichtung von waferintegrierten elektronischen Vorrichtungen des Typs, welche eine Vielzahl von Kontaktsonden (34) umfassen, wobei jede Kontaktsonde (34) zumindest eine Kontaktspitze, welche geeignet ist, gegen Kontaktpads einer waferintegrierten zu testenden Vorrichtung (35) anzuliegen, sowie ein Kontaktelement für die Verbindung mit einer Karte (36) der Testeinrichtung aufweist, **dadurch gekennzeichnet, dass** er zumindest eine Schnittstellenkarte (50) nach einem der vorhergehenden Ansprüche umfasst.

12. Verfahren zum Realisieren einer Schnittstellenkarte (50) eines Prüfkopfes (31) für eine Testeinrichtung von waferintegrierten elektronischen Vorrichtungen, wobei der Prüfkopf (31) eine Vielzahl an Kontaktsonden (34) umfasst, wobei jede Kontaktsonde (34) zumindest eine Kontaktspitze umfasst, welche geeignet ist, gegen Kontaktpads einer zu testenden Vorrichtung (35) anzuliegen, welche auf einem Wafer integriert oder in einem Wafer enthalten sind, sowie ein Kontaktelement für die Verbindung mit einer Karte (36) der Testeinrichtung, wobei das Verfahren die Schritte umfasst:
- Bereitstellen eines Substrats (51) für die Schnittstellenkarte (50), welche mit der Leiterplattentechnik realisiert wird;
- Integrieren einer Umleitungs-Die (40) auf einem Halbleitersubstrat (41), durch Verwendung der Integrationstechniken der integrierten Schaltungen;
- Unterbringen der Umleitungs-Die (40) an einer ersten Oberfläche des Substrats (51) der Schnittstellenkarte (50); und
- elektrisches Verbinden einer Vielzahl von Kontaktpads des Umleitungs-Die (40) mit einer Vielzahl an Kontaktstiften (53), welche aus einer zweiten Oberfläche des Substrats (51) hervorstehen, welche entgegengesetzt zu der ersten Oberfläche ist, worauf der Umleitungs-Die (40) untergebracht ist,
wobei die Kontaktstifte (53) geeignet sind zugehörige Kontaktpads einer Karte (36) zum Realisieren einer gewünschten Verbindung mit der Testeinrichtung zu verbinden.

13. Verfahren gemäß Anspruch 12, **dadurch gekennzeichnet, dass** der Schritt des Integrierens des Umleitungs-Dies (40) auf dem Halbleitersubstrat (41) die Schritte umfasst:
- Realisieren einer ersten Vielzahl von Kontaktpads (42), welche in einem ersten zentralen Anteil (42) des Umleitungs-Die (40) verteilt sind;
- Realisieren einer zweiten Vielzahl von Kontaktpads (43A), welche in einem zweiten Randanteil (43) des Umleitungs-Die (40) verteilt sind, wobei der zweite Randanteil (43) eine ringförmige Form um den zentralen Anteil (42) aufweist; und
- Realisieren einer Vielzahl von metallischen Verbindungsbahnen (44), welche geeignet sind, um die Kontaktpads (42A) des ersten zentralen Anteils (42) mit den Kontaktpads (43A) des zweiten Randanteils (43) der Umleitungsmatrize (40) zu verbinden.

14. Verfahren gemäß Anspruch 12, **dadurch gekennzeichnet, dass** der Schritt des Integrierens des Umleitungs-Die (40) an dem Halbleitersubstrat (41) die Schritte der Backend-Maskierung, welche in den Integrationstechniken der integrierten Schaltung verwendet wurden, zum Realisieren der Kontakte und der Verbindungen umfasst.

15. Verfahren gemäß Anspruch 13, **dadurch gekennzeichnet, dass** es weiter die Schritte umfasst:
- Realisieren einer Vielzahl von metallischen Pads (52) auf dem Substrat (51) der Schnittstellenkarte (50), in elektrischer Verbindung mit den Kontaktstiften (53); und
- Verbinden der metallischen Pads (52) zu den Kontaktpads (43A) des zweiten Randanteils (43) des Umleitungs-Die (40) mittels Bonddrähte (54).

## Revendications

1. Carte d'interface (50) d'une tête de test (31) pour un équipement de test de dispositifs électroniques à plaquettes intégrées, ladite tête de test (31) comprenant une pluralité de sondes de contact (34), chaque sonde de contact (34) présentant au moins une pointe de contact apte à buter contre les pastilles de contact d'un dispositif devant être testé (35) intégré sur et inclus dans une plaquette, ainsi qu'un élément de contact pour la connexion avec une carte (36) dudit équipement de test, **caractérisé en ce qu'**elle comporte un substrat (51) et au moins un dé de redirection (40) logé sur une première surface dudit substrat (51) et une pluralité de broches de contact (53) en saillie à partir d'une seconde surface dudit substrat (51) opposée à ladite première surface, ledit dé de redirection (40) comprenant au moins un substrat semi-conducteur (41) sur lequel au moins une première pluralité de pastilles de contact (42A) est réalisée, lequel est pertinent pour établir un contact avec un élément de contact d'une sonde de contact (34) de ladite tête de test (31), lesdites broches de contact (53) étant pertinentes pour contacter ladite carte (36).

2. Carte d'interface (50) selon la revendication 1, **caractérisée en ce que** lesdites pastilles de contact (42A) de ladite première pluralité sont distribuées dans une première partie centrale (42) dudit dé de redirection (40) avec une distribution spatiale correspondant sensiblement à une distribution spatiale d'une pluralité de pastilles de contact dudit dispositif devant être testé (35).

3. Carte d'interface (50) selon la revendication 2, **caractérisée en ce qu'**elle comporte en outre une seconde pluralité de pastilles de contact (43A) distribuée dans une seconde partie périphérique (43) dudit dé de redirection (40) et connectée auxdites pastilles de contact (42A) de ladite première pluralité au moyen d'une pluralité de pistes d'interconnexion métalliques (44) réalisée dans ledit substrat (41) dudit dé de redirection (40), ladite seconde partie périphérique (43) entourant ladite première partie centrale (42).

4. Carte d'interface (50) selon la revendication 1, **caractérisée en ce qu'**elle comprend en outre une pluralité de pastilles métalliques (52) réalisée sur une partie périphérique dudit substrat (51) de ladite carte d'interface (50) laissée exempte dudit dé de redirection (40) et connectée auxdites broches de contact (53).

5. Carte d'interface (50) selon la revendication 4, **caractérisée en ce qu'**elle comporte une pluralité de fils de connexion (54) pertinente pour connecter lesdites pastilles métalliques (52) auxdites pastilles de contact (43A) de ladite seconde pluralité.

6. Carte d'interface (50) selon la revendication 1, **caractérisée en ce que** ledit dé de redirection (40) comprend un boîtier de type à matrice de broches, PGA, sans couvercle.

7. Carte d'interface (50) selon la revendication 3, **caractérisée en ce que** ledit dé de redirection (40) comporte des connexions par liaison de fils de connexion directe entre ladite seconde pluralité de pastilles de contact (43A) et des pastilles de contact agencées dans ladite carte (36) dudit équipement de test.

8. Carte d'interface (50) selon la revendication 3, **caractérisée en ce que** ledit dé de redirection (40) comporte des connexions de type interconnexions verticales, TSV, entre les deux surfaces en correspondance avec lesdites pastilles de contact (43A) de ladite seconde pluralité.

9. Carte d'interface (50) selon l'une quelconque des revendications précédentes, **caractérisée en ce qu'**elle comporte au moins un module de test en parallèle (60) incluant à son tour une pluralité de dés de redirection (40) qui sont agencés sous la forme d'une matrice et convenablement espacés les uns des autres par rapport à des passages de séparation (62, 63).

10. Carte d'interface (50) selon la revendication 9, **caractérisée en ce que** ledit module de test en parallèle (60) comprend une pluralité de fentes (62A, 63A) réalisée dans lesdits passages de séparation (62, 63) adéquate pour traverser un substrat (61) dudit module de test en parallèle (60) de manière à loger des fils de connexion (54) pour la connexion avec des pastilles métalliques réalisées sur ledit substrat (51) de ladite carte d'interface (50) en correspondance avec lesdites fentes (62A, 63A).

11. Tête de test pour un équipement de test de dispositifs électroniques à plaquettes intégrées du type comprenant une pluralité de sondes de contact (34), chaque sonde de contact (34) présentant au moins une pointe de contact apte à buter contre des pastilles de contact d'un dispositif à plaquettes intégrées devant être testé (35), ainsi qu'un élément de contact pour la connexion avec une carte (36) dudit équipement de test, **caractérisée en ce qu'**elle comporte au moins une carte d'interface (50) selon l'une quelconque des revendications précédentes.

12. Procédé de réalisation d'une carte d'interface (50) d'une tête de test (31) pour un équipement de test de dispositifs électroniques à plaquettes intégrées, ladite tête de test (31) comprenant une pluralité de sondes de contact (34), chaque sonde de contact (34) présentant au moins une pointe de contact apte à buter contre les pastilles de contact d'un dispositif devant être testé (35) intégré sur et inclus dans une plaquette, ainsi qu'un élément de contact pour la connexion avec une carte (36) dudit équipement de test, le procédé comprenant les étapes suivantes consistant à :
- fournir un substrat (51) pour ladite carte d'interface (50) réalisée au moyen des techniques de circuit imprimé ;
- intégrer un dé de redirection (40) sur un substrat semi-conducteur (41) en utilisant les techniques d'intégration des circuits intégrés ;
- loger ledit dé de redirection (40) sur une première surface dudit substrat (51) de ladite carte d'interface (50) ; et
- connecter électriquement une pluralité de pastilles de contact dudit dé de redirection (40) avec une pluralité de broches de contact (53) en saillie à partir d'une seconde surface dudit substrat (51) opposée à ladite première surface sur laquelle ledit dé de redirection (40) est logé ;
lesdites broches de contact (53) étant pertinentes pour établir un contact avec les pastilles de contact correspondantes d'une carte (36) en vue de réaliser la connexion souhaitée avec ledit équipement de test.

13. Procédé selon la revendication 12, **caractérisé en ce que** ladite étape d'intégration dudit dé de redirection (40) sur ledit substrat semi-conducteur (41) comprend les étapes suivantes consistant à :
- réaliser une première pluralité de pastilles de contact (42) distribuée dans une première partie centrale (42) dudit dé de redirection (40) ;
- réaliser une seconde pluralité de pastilles de contact (43A) distribuée dans une seconde partie périphérique (43) dudit dé de redirection (40), ladite seconde partie périphérique (43) présentant une forme de type annulaire autour de ladite première partie centrale (42) ; et
- réaliser une pluralité de pistes d'interconnexion métalliques (44) adéquate pour connecter lesdites pastilles de contact (42A) de ladite première partie centrale (42) auxdites pastilles de contact (43A) de ladite seconde partie périphérique (43) dudit dé de redirection (40).

14. Procédé selon la revendication 12, **caractérisé en ce que** ladite étape d'intégration dudit dé de redirection (40) sur ledit substrat semi-conducteur (41) comprend les étapes de masquage d'extrémité dorsale utilisées dans les techniques d'intégration des circuits intégrés pour réaliser les contacts et les connexions.

15. Procédé selon la revendication 13, **caractérisé en ce qu'**il comprend en outre les étapes suivantes consistant à :
- réaliser une pluralité de pastilles métalliques (52) sur ledit substrat (51) de ladite carte d'interface (50), en connexion électrique avec lesdites broches de contact (53) ; et
- connecter lesdites pastilles métalliques (52) auxdites pastilles de contact (43A) de ladite seconde partie périphérique (43) dudit dé de redirection (40) au moyen de fils de connexion (54).
